# EUROPÄISCHE PATENTSCHRIFT

(11) **EP 2 828 164 B1**
(45) Veröffentlichungstag und Bekanntmachung des Hinweises auf die Patenterteilung: **23.09.2015**
(21) Anmeldenummer: 13716171.7
(22) Anmeldetag: 18.03.2013
(51) Int. Cl.: B64D 15/20, F03D 11/00, G08B 19/02, B64D 15/22, G01R 27/26

(54) **VORRICHTUNG ZUM ERFASSEN KRITISCHER ZUSTÄNDE EINER OBERFLÄCHE**
DEVICE FOR DETECTING CRITICAL STATES OF A SURFACE
DISPOSITIF DE DÉTERMINATION DES ÉTATS CRITIQUES D'UNE SURFACE

(30) Priorität: 19.03.2012 AT 3292012
(43) Veröffentlichungstag der Anmeldung: 28.01.2015
(73) Patentinhaber: Moser, Michael, 8010 Graz (AT); Zangl, Hubert, 8051 Graz (AT)
(72) Erfinder: Moser, Michael, 8010 Graz (AT); Zangl, Hubert, 8051 Graz (AT)
(74) Vertreter: Patentanwaltskanzlei Matschnig & Forsthuber OG
(86) Internationale Anmeldenummer: PCT/AT2013/050066
(87) Internationale Veröffentlichungsnummer: WO 2013/138832

(56) Entgegenhaltungen:
- WO-A2-2009/052828
- WO-A2-2011/117246
- CN-A- 101 285 673
- DE-A1-102007 001 507

## Beschreibung

### Technisches Gebiet

Die Erkennung von Eisbildung an Flächen (auch Oberflächen) wie z.B. an den Rotorblättern von Windenergieanlagen kann zur Einhaltung sicherer Betriebsbedingungen wesentlich beitragen. Im Bereich von Windenergieanlagen verursacht ein Eisbelag einen geringeren Energieertrag und höhere mechanische Beanspruchung der Anlage und birgt gleichzeitig die Gefahr des Eisabwurfs (eine Gefahr sowohl für Menschen als auch für Sachgüter). Bereits dünne Schichten verursachen durch die turbulente Strömung an der Oberfläche bedingt durch größere Rauigkeit relevante Ertragseinbußen. Dickere Schichten können durch verstärkte Vibrationen und Unwucht zu Schäden an der Maschine und bei Abwurf zu Schäden führen. Man ist nun als Betreiber von Windkraftanlagen an gefährdeten Standorten interessiert, den Grad der Vereisung der Rotorblätter so gut wie möglich zu kennen, um die Windkraftanlage rechtzeitig abzuschalten, bevor Schäden auftreten oder aber eine evtl. vorhandene elektrische Heizung der Rotorblätter gezielt zu aktivieren.

Eisbildung ist aber auch in anderen Bereichen wie beispielsweise an Straßen, Flugzeugtragflächen oder Antennen ein relevantes Phänomen, dessen frühe Erkennung und Beseitigung durch geeignete Maßnahmen einen störungsfreien Betrieb erleichtert.

### Stand der Technik

Gegenwärtige kommerzielle Systeme zur Detektion von Vereisung sind typischerweise komplexe Messgeräte und im Umfeld von Windenergieanlagen aufgrund ihrer Baugröße fix montiert und benötigen durch ihren Aufbau typischerweise einen Stromanschluss (z.B. optische und ultraschallbasierte Systeme). Es ist in Fachkreisen bekannt, dass sich das Aneisungsverhalten z.B. bei Windenergieanlagen am Standort der Gondel und an den Rotorblättern wesentlich unterscheiden kann (z.B. durch die aus der Rotation resultierende höhere Windgeschwindigkeit). Daher wurden weiters Systeme entwickelt, die das Aneisungsverhalten der Rotorblätter untersuchen, z.B. durch Überwachung des Zustandes des Rotorblattes mittels Eigenfrequenzanalyse. Dieses System birgt den Nachteil, dass nicht ausschließlich Eisbelag zur Änderung der Eigenfrequenzen führen kann. Weiters liegt die Detektionsschwelle verhältnismäßig hoch (ca. 4% Gewichtsänderung) und es ist keine Lokalisation der Eisschicht möglich. Weiters ist ein System bekannt, das ein optisches Eisdetektionsprinzip verwendet, indem optische Fasern von innen her an die Oberfläche des Rotorblattes geführt werden (DE 102005017716 A1). Dies bedingt den Einbau eines komplexen Messgerätes in das Rotorblatt und damit hohen Installationsaufwand, weiters Verletzungen der Oberfläche und es erlaubt die Messung nur an einigen wenigen Punkten pro Rotorblatt.

Verfahren zur Detektion von Feuchtigkeit oder Luftfeuchtigkeit durch Absorption an einen porösen Träger und Auswertung einer komplexen Impedanz werden zum Beispiel in FR 2750494 A1 und US5177662 beschrieben. Diese Verfahren sind jedoch prinzipbedingt nicht in der Lage, das Vorhandensein von Eis bzw. eine Schichtdicke zu detektieren, da das auf Absorption basierende Verfahren bedingt, dass Feuchtigkeit ins Innere des Sensors eindringen kann.

Demgegenüber sind Verfahren zur Eisdetektion bekannt, die auf der Messung der elektrischen Kapazität oder Impedanz basieren (z.B. US 5398547). Diese Verfahren eignen sich besonders für einen planaren Aufbau mit geringer Bauhöhe.

DE 10205017716 verwendet das drahtlose Senden von Signalen über eine Übertragungsstrecke zu einem Empfänger als Messprinzip zur Erfassung von Ablagerungen als Hindernisse in einem optischen Übertragungsweg als Methode zur Eisdetektion an der Oberfläche eines Rotorblatts. WO 2009/052828 wird als nächstliegender Stand der Technik angesehen.

### Aufgabe der Erfindung

Die Aufgabe stellt sich wie folgt dar: eine Vorrichtung zum Erfassen kritischer Oberflächenzustände, wobei die besonders gefährdeten Flächen typischerweise nicht eben (plan) sind (z.B. bei Flugzeugen, Rotorblättern, Hochspannungsisolatoren oder Antennen). Die Flächenform bzw. deren Beschaffenheit darf durch den Sensor nicht bzw. nicht maßgeblich verändert werden, um beispielsweise das Verhalten hinsichtlich einer Aneisung nicht oder nur minimal zu verändern. Die Aerodynamik darf durch die Vorrichtung nicht oder nur wenig beeinflusst werden. Als Eis im Sinne der Erfindung sind alle Arten von gefrorenem Wasser auch in Mischung mit flüssigem Wasser zu verstehen. Gegebenenfalls können auch eine Klassifizierung der Eisart oder die Erkennung von Situationen, in denen sicher kein Eis an der Oberfläche vorhanden ist, von Interesse sein. Im Sinne der Erfindung umfasst Wasser auch Mischungen aus Wasser und Verunreinigungen der Oberfläche.

Als kritische Oberflächenzustände im Sinne der Erfindung sind insbesondere folgende Szenarien zu verstehen: Wasser und/oder Eis und/oder Mischungen davon an Oberflächen (z.B. Rotorblättern) von Windkraftanlagen, Eis und/oder Wasser und/oder Verunreinigungen an Hochspannungsisolatoren. Dabei ist ein Ziel der Erfindung, sich in Entstehung befindliche kritische Zustände zu erfassen, sodass Gegenmaßnahmen in einem Zeitfenster ergriffen werden können, in dem diese kritischen Zustände noch beherrschbar sind.

Die gegenständliche Erfindung löst die Aufgabe unter anderem dadurch, dass die Vorrichtung, die eine Einrichtung zur Detektion von Eis und/oder Wasser, zur Energieversorgung und zur Datenübertragung beinhaltet, wenigstens teilweise mechanisch flexibel ausgeführt ist, sodass eine Anpassung an nicht ebene Flächen möglich ist. Die Vorrichtung kann hermetisch abgedichtet sein, d.h. kein Wasser bzw. Luftfeuchtigkeit kann ins Innere des Sensors eindringen; insbesondere die Grenzfläche zur Umgebung ist keinesfalls porös. Durch die Integration in eine Einheit und die geometrische Form (unter anderem durch die geringen Bauhöhe im Verhältnis zur Länge und Breite) sind eine erstmalige aber auch eine nachträgliche Anbringung der Vorrichtung an einer zu erfassenden Fläche auf einfache Art und Weise und ohne große Veränderungen an der Fläche möglich. Die erfassten und ausgewerteten Daten können drahtlos oder drahtgebunden an eine weitere Vorrichtung oder an eine Basisstation übertragen werden, wobei sich diese nicht zwingend im Rotorblatt befinden müssen sowie mit Sender und Empfänger keine mechanische Einheit bilden.

Weitere Details zu Ausführungsformen und Vorteile der gegenständlichen Erfindung sind im Weiteren ausgeführt.

Die Anbringung an nicht ebenen Oberflächen bedingt eine flexible Ausführung vor allem großflächiger Bauelemente, insbesondere eine wenigstens teilweise flexible Trägerplatte, die beispielsweise aus zwei flexiblen Leiterplatten, die gleichzeitig die Außenhaut,darstellen können, mit dazwischen liegendem Füllstoff (beispielsweise Polymerverguss) ausgeführt ist, wodurch eine mechanische Verbindung aller Komponenten gewährleistet ist.

Weiters erforderlich sind eine geringe Stärke der einzelnen Komponenten und kleine Abmessungen starrer Bauelemente. Die Gesamtdicke liegt im niedrigen einstelligen Millimeterbereich; Dicken von unter 5 mm sind vorteilhaft und erlauben ein Verhältnis zwischen der größeren Seitenlänge und der Dicke der Vorrichtung größer als 10.

Der Sensor zur Eisdetektion und/oder Eisdickenmessung und/oder Eisklassifizierung kann beispielsweise als kapazitiver Sensor ausgeführt sein. Ein kapazitiver Sensor zur Eisdetektion und/oder Eisdickenmessung besteht aus mehreren Elektroden aus leitfähigen Strukturen, die beispielsweise auf einem flexiblen, nicht porösen, idealerweise hermetisch abdichtenden Trägermaterial, (d.h. geringe Wasseraufnahme/geringe Wasserdurchlässigkeit des Trägermaterials) aufgebracht sein können, und einer Auswerteeinheit, die Kapazitäten zwischen weitgehend planar angeordneten Elektroden misst und daraus einen Wert zur Detektion und/oder Dicke zurückliefert. Das Material der Grenzfläche zwischen Sensor und Außenwelt soll ebenfalls weitgehend hermetisch abdichten, das heißt, dass das Material nahezu keine Durchlässigkeit oder Aufnahmefähigkeit für Wasser bzw. Wasserdampf aufweist.

Andere, in der Vorrichtung enthaltene Sensoren können beispielsweise Helligkeit, Schwingungen, Temperatur und/oder elektrische Ströme messen. Dabei sind vor allem Kriechströme (Gleich- und Wechselströme) entlang isolierender Oberflächen wie beispielsweise Hochspannungsisolatoren, auf denen die Vorrichtung angebracht werden kann, von Interesse.

Die Montage der Vorrichtung kann durch Klebung auf eine zu beobachtende Oberfläche (mit oder ohne Aufbringung von weiteren Schutzschichten über der Vorrichtung) oder durch Einbettung z.B. in äußere Schichten eines Rotorblatts während des Herstellungsprozesses erfolgen. Dadurch sind keine mechanischen Eingriffe (Bohrlöcher, Schlitze, Ausnehmungen) in die zu beobachtende Oberfläche notwendig.

Bei der Klebung können beispielsweise selbstklebende Folien (oberhalb oder unterhalb der Vorrichtung), Sprühkleber, flüssige Klebstoffe sein. In einer bevorzugten Ausführungsform wird ein Klebstoff bereits im Herstellungsprozess auf der Vorrichtung appliziert und mit einer Schutzfolie bis zur Montage abgedeckt, sodass bei einer Montage nur die Schutzfolie abgezogen werden muss und die Vorrichtung an der zu beobachtenden Oberfläche unmittelbar angebracht werden kann.

Eine typische Oberflächenbehandlung kann (sofern elektrisch nicht oder nur gering leitfähig) auch oberhalb der Vorrichtung appliziert werden, sodass die ursprüngliche Oberflächenbeschaffenheit gewährleistet bleibt.

Die für den Betrieb notwendige elektrische Energie kann aus der Umgebung gewonnen werden: es sind dies zum Beispiel flexible Solarzellen auf Basis von GaAs oder amorphem Silizium. Weiters kann eine Energiegewinnung aus Wärme (thermoelektrischer Generator) oder aus Vibrationen der Oberfläche eingesetzt werden. Es sind dies ebenfalls Technologien, die mit geringer Bauhöhe und/oder weitgehend flexibel realisiert werden können.

Die für den Betrieb notwendige elektrische Energie wird in einem Energiespeicher zwischengespeichert. Diese typischerweise wieder aufladbaren Energiespeicher können auch in flexibler Ausführung realisiert werden. Es können dies beispielsweise Akkumulatoren oder Kondensatoren (auch Supercaps etc.) sein. Weiters kann auch eine (flexible) Primärzelle (Batterie) verwendet werden.

Die Datenübertragung der erfassten Messdaten kann vorteilhaft drahtlos (d.h. z.B. über optische Übertragungsstrecken oder per Funk) erfolgen, um neben einer Verbindung zur Stromversorgung auch Verbindungen für die Datenübertragung obsolet zu machen; somit sind keine Verkabelungen notwendig. In diesem Falle kann die Vorrichtung vollständig hermetisch abgedichtet werden, d.h. kein Stoff (z.B. Wasser oder Luftfeuchtigkeit) kann in das Innere der Vorrichtung eindringen. Dies erhöht die Robustheit des Systems.

Mehrere solcher Vorrichtungen können optional untereinander kommunizieren, um einerseits die von der Datenübertragung per Funk zu überbrückende Strecke (und damit den Energiebedarf) zu limitieren, und andererseits die Ausfallssicherheit und die statistische Qualität der Messdaten zu erhöhen.

Eine mögliche Anwendung solcher Vorrichtungen ist die Eisdetektion und/oder die Eisdickenmessung an der Oberfläche von Rotorblättern von Windenergieanlagen. Hier kann die Vorrichtung weiters dazu benutzt werden, Einrichtungen zur Abtauung der Oberflächen von Rotorblättern (z.B. Warmluftgebläse, Flächenheizer) zu steuern. Das geringe Gewicht, die geringe Bauhöhe und die Langlebigkeit der Vorrichtung sind hierbei von besonderem Nutzen. Dabei kann die Vorrichtung beispielsweise in eine Flächenheizung integriert und gemeinsam aufgebracht werden, wodurch die Vorrichtung mit der Einrichtung zur Abtauung eine mechanische Einheit bilden kann. Hier besteht die Möglichkeit, den Wärmestrom aus der Heizung in die Umgebung zur thermoelektrischen Energiegewinnung zu nutzen. Weiters besteht die Möglichkeit, leitfähige Teile der Heizung als Elektroden für Eisdetektion oder Eisdickenmessung (kapazitive Eissensorik) zu verwenden, wodurch die Vorrichtung auch elektrisch eine Einheit mit der Einrichtung zur Abtauung bilden kann. Unter bestimmten Umständen kann die Vorrichtung auch an der Innenseite des Rotorblattes angebracht werden.

Die Erfindung bezieht sich auf eine Vorrichtung zur Detektion und Dickenmessung von Eis und Wasser auf Oberflächen und zeichnet sich dadurch aus, dass die Baugruppen für Energiegewinnung aus der Umwelt, Energiespeicherung, Datenverarbeitung und drahtlose Datenübertragung bereits in der Vorrichtung enthalten sind, wobei die gesamte Vorrichtung dünn und flexibel ausgeführt ist. Somit lässt sich die Vorrichtung ohne größere mechanische Eingriffe in das mit der Vorrichtung auszustattende Objekt, auch nachträglich, anbringen. Die einzelnen Vorrichtungen können optional nicht nur mit einer Basisstation, sondern auch untereinander kommunizieren, arbeiten aber unabhängig voneinander.

Die vorliegende Erfindung stellt sich wie folgt dar: eine Vorrichtung zur Detektion kritischer Oberflächenzustände (z.B. Quantifizierung von Eis und Wasser an Oberflächen), wobei alle Baugruppen für Energieversorgung und Datenverarbeitung sowie Datenübertragung in der Vorrichtung enthalten sind sowie die gesamte Vorrichtung dünn (Bauhöhe unter 5 mm bzw. Verhältnis zwischen der größeren Seitenlänge und der Dicke >10) und wenigstens teilweise flexibel (biegsam) ausgeführt ist. Durch die geringe Bauhöhe werden Veränderungen der Aerodynamik minimiert und somit auch Änderungen im Aneisungsverhalten durch die Vorrichtung vermieden.

### Aufzählung der Zeichnungen

Die Erfindung wird anhand eines Ausführungsbeispiels gemäß den Zeichnungen näher erläutert, wobei
Fig. 1 ein beispielhaftes Blockschaltbild der Vorrichtung darstellt,
Fig. 2 eine beispielhafte Ausführungsform der Vorrichtung im Profil zeigt,
Fig. 3 eine Draufsicht auf eine beispielhafte Ausführungsform der Vorrichtung zeigt und
Fig. 4 beispielhaft ein Rotorblatt mit möglichen Montageorten für die Vorrichtung zeigt.
Fig. 5 beispielhaft die Montage der Vorrichtung auf einem elektrischen Isolator zeigt.

### Ausführliche Beschreibung unter Verwendung der Bezugszeichen in der Zeichnung

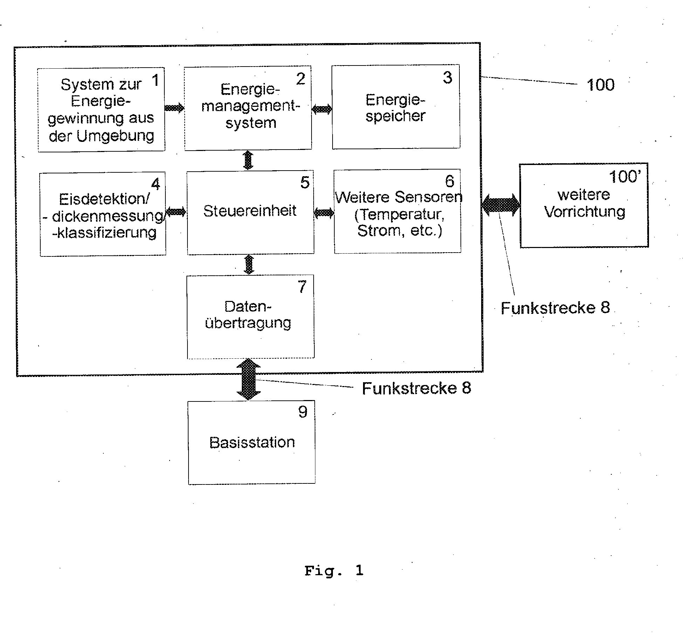

Wie in Fig. 1 dargestellt, enthält die Vorrichtung 100 neben einem Sensor zur Eisdetektion und/oder Eisdickenmessung und/oder Eisklassifizierung 4 ein System zur Energiegewinnung aus der Umgebung 1 (z.B. aus Sonnenstrahlung, Wärme, Vibrationen oder Kriechströmen, elektrisches/magnetisches/elektromagnetisches Feld). Diese Energiequellen stehen typischerweise nicht kontinuierlich zur Verfügung, weshalb die Energie in einem Energiespeicher 3 zwischengespeichert werden kann. Beide Baugruppen werden optional flexibel und dünn ausgeführt. Die Regelung wird von einem Energiemanagementsystem 2 ausgeführt.

Eine Steuereinheit 5 (beispielsweise ein Mikroprozessor) wird von Energiespeicher 3 oder dem System zur Energiegewinnung aus der Umgebung 1 mit elektrischer Energie versorgt und erfasst Messdaten des Sensors zur Eisdetektion und/oder Eisdickenmessung und/oder Eisklassifizierung 4. Diese Daten können mit weiteren Messdaten aus weiteren Sensoren 6 (z.B. Temperatur, Strom) verarbeitet werden und werden über eine Einrichtung zur Datenübertragung 7 z.B. drahtlos über eine Funkstrecke 8 an eine weitere Vorrichtung 100' oder eine Basisstation 9 weitergeleitet. Je nach Standort und Umgebungsbedingungen können unterschiedliche Einrichtungen zur Energiegewinnung und -speicherung (auch mehrere Systeme in einer Vorrichtung 100) vorgesehen werden.

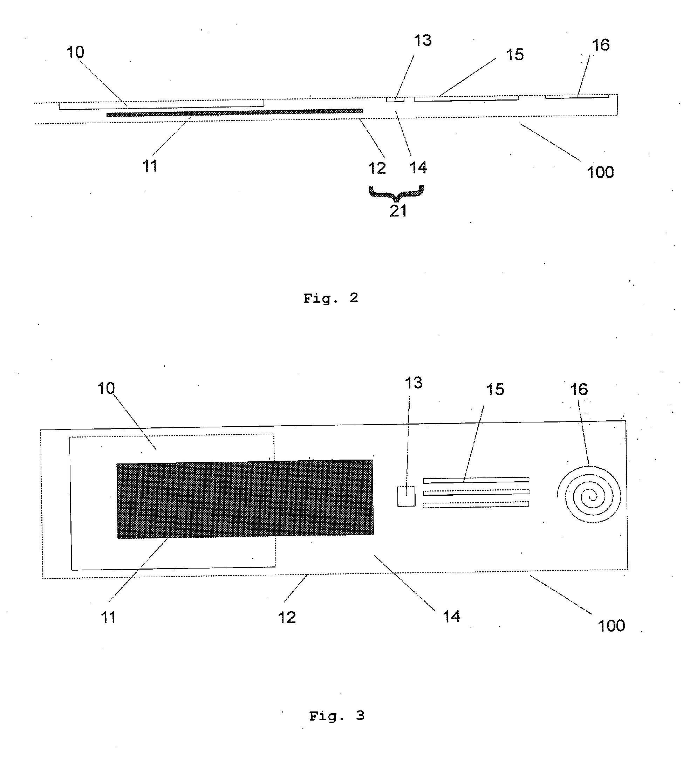

Fig. 2 und 3 zeigen den beispielhaften schematischen Aufbau der Vorrichtung: eine starre oder flexible Solarzelle 10 liegt an oder unter einer zu beobachtenden Fläche und wird durch eine zumindest teilweise lichtdurchlässige Schutzschicht von der Umgebung getrennt. Eine flexible Batterie 11 befindet sich innerhalb der Vorrichtung 100, die von einer Außenhaut 12 (beispielsweise eine flexible Leiterplatte) umgeben ist. Der gesamte Innenraum wird mit einem (ggf. verstärkten) Füllstoff 14 (z.B. einem Polymer), gefüllt. Die Außenhaut 12, die beispielsweise als flexible Leiterplatte ausgeführt sein kann, bildet mit dem Füllstoff 14 eine mechanische Einheit mit der Funktion der flexiblen Trägerplatte 21. Ebenfalls innerhalb der Vorrichtung 100 liegen weitere Einrichtungen z.B elektronische Komponenten und integrierte Bausteine 13 für Datenverarbeitung, Messung und Datenübertragung. Die Elektroden für eine Eisdetektion oder Eisdickenmessung 15 befinden sich unter der zu beobachtenden Fläche der Vorrichtung 100. Die Funkantenne 16 ist ebenfalls in der Vorrichtung 100 integriert und kann ebenfalls unter der zu beobachtenden Oberfläche 0 liegen.

Durch die beschriebenen Merkmale kann die Vorrichtung 100 gegebenenfalls hermetisch abgedichtet (vollständig elektrisch isoliert) werden, wodurch eine besonders lange uneingeschränkte Betriebsdauer realisiert werden kann. Weiters ist die gesamte Vorrichtung 100 dünn (Bauhöhe unter 5 mm bzw. Verhältnis zwischen größter Seitenlänge und Dicke größer als 10) und flexibel (biegsam) ausgeführt. Die flexible Ausführung großflächiger, dünner Bauelemente bei gleichzeitiger Verwendung eines flexiblen Trägermaterials, die Anordnung der Komponenten zueinander und kleine Abmessungen von starren Komponenten tragen wesentlich zur Flexibilität der Vorrichtung 100 bei.

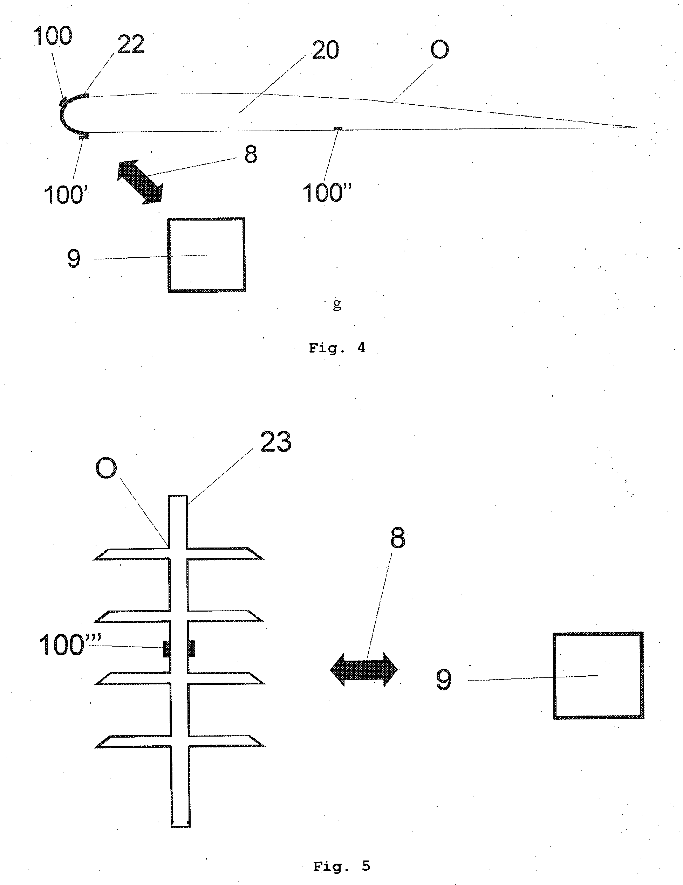

Fig. 4 zeigt drei von vielen möglichen Montagepositionen der Vorrichtung 100 auf einem Rotorblatt 20 einer Windenergieanlage: Vorrichtung 100 und Vorrichtung 100' an der Vorderkante des Rotorblattes 20 sind deutlich relevanter positioniert als Vorrichtung 100", da erfahrungsgemäß Aneisungen an der Vorderkante beginnen und je nach Hersteller auch nur dieser Bereich mit einer Einrichtung zur Abtauung 22 ausgerüstet wird. Typischerweise ist gerade an diesen Positionen die Krümmung der Oberfläche 0 des Rotorblattes 20 besonders stark ausgeprägt, was eine zumindest teilweise flexible Vorrichtung 100 zur Messung notwendig macht. Gleichzeitig sind gerade an der Vorderkante Eingriffe in die Aerodynamik kritisch. Daher ist eine Befestigungsart mit möglichst geringem Bauhöhenbedarf (Klebung oder Integration durch Laminierung) und eine geringe Bauhöhe der Vorrichtung 100 notwendig. Schutzschichten über der Vorrichtung 100 sind - sofern nichtleitend und gegebenenfalls transparent- unproblematisch. Außerdem kann durch Verwendung ähnlicher Materialien und vergleichbare Bauhöhe die Vorrichtung 100 z.B. in eine Flächenheizung derart integriert werden, dass eine gemeinsame Montage bzw. die gemeinsame Nutzung leitfähiger Strukturen möglich ist.

Die erfassten Messdaten werden z.B. per Funk in einem Sensornetz an eine weitere Vorrichtung 100' oder Vorrichtung 100" zur Weiterübermittlung weitergereicht oder werden direkt an eine Basisstation 9 zur Auswertung und/oder zur Steuerung einer Einrichtung zur Abtauung 22 übertragen. Dabei kann die Ausführung als Sensornetz vorteilhaft sein, um die von der Funkübertragung zu überbrückende Strecke (und damit den Energiebedarf) zu reduzieren; andererseits sind mehrere Messpunkte sinnvoll, um die Redundanz des Systems zu gewährleisten und die hohe Qualität der erfassten Werte zu gewährleisten.

Fig. 5 zeigt eine von vielen möglichen Montagepositionen der Vorrichtung 100: Die Anbringung der Vorrichtung 100"' an der Oberfläche O eines Isolators 23 von Hochspannungsübertragungseinrichtungen (z.B. Freileitungsmast, Transformatordurchführung) erlaubt bei geeigneter Ausführungsform (z.B. ringförmig, Anbringung an Montageposition 24) die Messung von unerwünschten Kriechströmen entlang solcher Oberflächen mittels kontaktierender oder kontaktloser Verfahren zur Strommessung (z.B. Rogowski-Spule, Fluxgate-Sensor, Shunt-Widerstand).

## Patentansprüche

1. Vorrichtung (100, 100 "') zum Erfassen kritischer Zustände an einer Oberfläche eines Bauteils (20), **gekennzeichnet durch**
eine zumindest teilweise flexible, an der Oberfläche (O) befestigbäre Trägerplatte (21), welche mit zumindest einem Sensor (4) zum Erfassen kritischer Zustände der Oberfläche, einem elektrischen Energiespeicher (3, 11), einer Einrichtung zur elektrischen Energiegewinnung, einer Steuereinheit (4) zum Erfassen und Verarbeiten der Sensordaten sowie einer Datenübertragungseinheit zur drahtlosen Datenübermittlung mechanisch in eine Einheit integriert ist, wobei zumindest der Sensor (4) hermetisch abgedichtet ist.

2. Vorrichtung (100,100"') nach Anspruch 1, **dadurch gekennzeichnet, dass** die Einrichtung zur elektrischen Energiegewinnung eine Solarzelle (10) aufweist.

3. Vorrichtung (100,100"') nach Anspruch 1 oder 2, **dadurch gekennzeichnet, dass** sie dünner als 5 mm ist.

4. Vorrichtung (100, 100"') nach einem der Ansprüche 1 bis 3, **dadurch gekennzeichnet, dass** sie auf die Oberfläche (O) aufklebbar ist.

5. Vorrichtung (100, 100"') nach einem der Ansprüche 1 bis 4, **dadurch gekennzeichnet, dass** sie unter der Oberfläche (O) in das Bauteil (20) integriert ist.

6. Vorrichtung (100, 100"') nach einem der Ansprüche 1 bis 5, **dadurch gekennzeichnet, dass** der Sensor (4) ein kapazitiver Sensor zum Erfassen einer Vereisung mit mehreren Elektroden (15) aus leitfähigen Strukturen ist.

7. Vorrichtung (100, 100"') nach einem der Ansprüche 1 bis 6, **dadurch gekennzeichnet, dass** der Sensor (4) an der Oberfläche (O) eines Bauteils (20) befestigbar ist, welche eine Einrichtung (22) zum Abtauen der Oberfläche aufweist, wobei die Vorrichtung zur Steuerung der Abtaueinrichtung (22) herangezogen ist.

8. Vorrichtung (100"') nach einem der Ansprüche 1 bis 4, **dadurch gekennzeichnet, dass** der Sensor zur Messung von Kriechströmen an der Oberfläche (O) eines Isolators (23) eingerichtet ist.

## Claims

1. A device (100, 100"') for detecting critical states on a surface of a component part (20), **characterised by**
an at least partially flexible carrier plate (21), which can be fastened to the surface (O) and which is mechanically integrated into a unit together with at least one sensor (4) for detecting critical states of the surface, an electrical energy store (3, 11), a device for electrical energy harvesting, a control unit (4) for detecting and processing the sensor data and also a data transfer unit for wireless data transfer, wherein at least the sensor (4) is hermetically sealed.

2. The device (100,100"') according to Claim 1, **characterised in that** the device for electrical energy harvesting comprises a solar cell (10).

3. The device (100, 100'") according to Claim 1 or 2, **characterised in that** it is thinner than 5 mm.

4. The device (100, 100"') according to one of Claims 1 to 3, **characterised in that** it can be adhered to the surface (O).

5. The device (100, 100'") according to one of Claims 1 to 4, **characterised in** it is integrated beneath the surface (O) into the component part (20).

6. The device (100, 100"') according to one of Claims 1 to 5, **characterised in that** the sensor (4) is a capacitive sensor for detecting icing with a number of electrodes (15) made of conductive structures.

7. The device (100, 100"') according to one of Claims 1 to 6, **characterised in that** the sensor (4) can be fastened to the surface (O) of a component part (20), which has a device (22) for defrosting the surface, wherein the device is used to control the defrosting device (22).

8. The device (100"') according to one of Claims 1 to 4, **characterised in that** the sensor is configured to measure leakage currents at the surface (O) of an insulator (23).

## Revendications

1. Système (100, 100"') pour la détection d'états critiques sur une surface d'un composant (20), **caractérisé par**
une plaque support (21) au moins partiellement flexible, fixable contre la surface (O), laquelle est mécaniquement intégrée dans une unité avec au moins un capteur (4) pour la détection d'état critiques de la surface, un accumulateur d'énergie électrique (3, 11), un dispositif de production d'énergie électrique, une unité de commande (4) pour la saisie et le traitement des données de capteur ainsi qu'une unité de transmission de données pour la transmission de données sans fil, au moins le capteur (4) étant hermétiquement étanchéifié.

2. Système (100, 100"') selon la revendication 1, **caractérisé en ce que** le dispositif de production d'énergie électrique comporte une cellule solaire (10).

3. Système (100, 100"') selon la revendication 1 ou 2, **caractérisé en ce que** l'épaisseur de celui-ci est inférieure à 5 mm.

4. Système (100, 100"') selon l'une des revendications 1 à 3, **caractérisé en ce que** celui-ci peut être collé contre la surface (O).

5. Système (100, 100"') selon l'une des revendications 1 à 4, **caractérisé en ce que** celui-ci est intégré au composant (20) sous la surface (O).

6. Système (100, 100"') selon l'une des revendications 1 à 5, **caractérisé en ce que** le capteur (4) est un capteur capacitif pour la détection d'un givrage, comportant plusieurs électrodes (15) ayant des structures conductrices.

7. Système (100, 100"') selon l'une des revendications 1 à 6, **caractérisé en ce que** le capteur (4) est fixable contre la surface (O) d'un composant (20), laquelle comporte un dispositif (22) pour le dégivrage de surface, le système étant sollicité pour la commande du dispositif de dégivrage (22).

8. Système (100"') selon l'une des revendications 1 à 4, **caractérisé en ce que** le capteur est prévu pour la mesure de courants de fuite sur la surface (O) d'un isolant (23).
